# EUROPÄISCHE PATENTANMELDUNG

(11) **EP 1 132 975 A1**
(43) Veröffentlichungstag der Anmeldung: **12.09.2001**
(21) Anmeldenummer: 01105205.7
(22) Anmeldetag: 03.03.2001
(51) Int. Cl.: H01L 31/173, H01L 31/12, C23C 14/48, H01L 21/3115

(54) **Integrierter Optokoppler und Verfahren zu seiner Herstellung**

(30) Priorität: 08.03.2000 DE 10011258
(71) Anmelder: Forschungszentrum Rossendorf e.V., 01328 Dresden (DE)
(72) Erfinder: Gebel, Thoralf, 01328 Dresden (DE); Skorupa, Wolfgang, Dr., 01108 Dresden (DE); von Borany, Johannes, Dr., 01326 Dresden (DE); Rehbole, Lars, Dr., 01139 Dresden (DE); Borchert, Dietmar, Dr., 45731 Waltrop (DE); Fahrner, Wolfgang R., Prof. Dr., 58097 Hagen (DE)

(57) **Zusammenfassung**

Der Erfindung liegt die Aufgabe zugrunde, einen integrierten Optokoppler und ein Verfahren zu seiner Herstellung vorzuschlagen, bei denen eine direkte Integration in Silizium-Technologie mit geringem Aufwand erfolgen kann, wobei Einschränkungen bei der Anwendung des Optokopplers weitgehend vermieden werden sollen.

Erfindungsgemäß wird die Aufgabe für den Optokoppler dadurch gelöst, dass das Sendeelement (1) aus einer nanoclusterhaltigen dielektrischen Schicht (5) besteht und dass Empfangs- und Sendeelement (1;2) aus einem monolithischen Block bestehen. Dabei können das Empfangs- und Sendeelement (1;2) vertikal übereinander oder lateral nebeneinander angeordnet sein.

Die erfindungsgemäße Lösung für das Verfahren beinhaltet, dass eine nanoclusterhaltige dielektrische Schicht durch Ionenstrahlsynthese erzeugt wird. Es ist auch möglich, dass eine nanoclusterhaltige SiOₓ-Schicht durch plasmagestützte Verfahren unter Variation der Stöchiometrie erzeugt und danach ausgeheilt wird.

## Beschreibung

Optokoppler dienen der rückwirkungsfreien Signalübertragung zwischen zwei galvanisch getrennten Stromkreisen. Der Primärkreis enthält dabei ein optisches Sendeelement, meist in Form einer LED im sichtbaren oder infraroten Wellenlängenbereich. Mittels eines Empfängers in Form einer Photodiode oder eines Phototransistors wird im Sekundärstromkreis das optische Signal detektiert und in ein elektrisches umgesetzt.

Optokoppler sind vor allem auf der Basis von Verbindungshalbleitern bekannt, wie GaAs/ AlGaAs, bei denen die Komponenten Emitter und Detektor separat hergestellt werden und dann durch eine entsprechende mechanische Anordnung über ein optisches Koppelmedium verbunden werden (M. Bleicher, Halbleiter-Optoelektronik, Hüthig - Verlag Heidelberg, 1986). Infolge der Komplexität eines derartigen Systems ist dieser Aufbau relativ aufwändig. Herkömmliche Optokoppler ermöglichen insbesondere durch die Verwendung von Verbindungshalbleitern für das Emitterelement keine direkte Integration in die herkömmliche Siliziumtechnologie.

Formen von bekannten integrierten Optokopplern beinhalten im allgemeinen den Aufbau von Empfängern auf einem Substrat und die Aufbringung einer Isolierschicht, auf die dann optische Sendeelemente als Einzelbauelemente aufgebracht werden (DE 3735489 A1). Als nachteilig erweist sich dabei die erforderliche Positionierung bei der Verbindung der Bauelemente.

Weitere Anordnungen sind in Form sogenannter Oberflächenkoppler bekannt. Dabei wird das Substrat als optisches Koppelmedium genutzt, auf dessen einer Seite ein Sender und auf der anderen Seite ein Empfänger aufgebaut ist. (DE 3633181 A1, DE 19546717 A1). Aufgrund der Anordnung von Sende- und Empfängerelement auf beiden Seiten des Substrats ergeben sich Einschränkungen hinsichtlich der Handhabbarkeit des Substrats.

Der Erfindung liegt die Aufgabe zugrunde, einen integrierten Optokoppler und ein Verfahren zu seiner Herstellung vorzuschlagen, bei denen eine direkte monolithische Integration des gesamten Optokopplers in Silizium-Technologie mit geringem Aufwand erfolgen kann, wobei Einschränkungen bei der Herstellung des Optokopplers weitgehend vermieden werden sollen.

Die Erfindung geht von einem Optokoppler aus, bei dem Empfangs- und Sendeelement benachbart angeordnet und durch ein optisch transparentes und elektrisch isolierendes Material galvanisch getrennt sind.
Erfindungsgemäß wird die Aufgabe für den Optokoppler dadurch gelöst, dass das Sendeelement aus einer nanoclusterhaltigen dielektrischen Schicht besteht und dass Empfangs- und Sendeelement aus einem monolithischen Block bestehen. Dabei können Empfangs- und Sendeelement vertikal übereinander oder lateral nebeneinander angeordnet sein. Die erfindungsgemäße Lösung für das Verfahren beinhaltet, dass eine nanoclusterhaltige SiO₂-Schicht durch Ionenstrahlsynthese, nämlich einer Kombination aus Ionenimplantation und Temperbehandlung, erzeugt wird. Es ist auch möglich, dass eine nanoclusterhaltige SiOₓ-Schicht durch plasmagestützte Verfahren, wie Plasmaoxidation, plasmagestützte CVD-Verfahren (PECVD) oder Plasmaimmersionsionenimplantation (PIII) - wobei eine Variation der Stöchiometrie erfolgt - erzeugt und danach ausgeheilt wird.

Die Erfindung wird nachstehend an zwei Ausführungsbeispielen für den Optokoppler und einem Ausführungsbeispiel für das Verfahren näher erläutert.
In der zugehörigen Zeichnung zeigen
- Fig. 1: einen erfindungsgemäßen Optokoppler im Querschnitt, bei dem Sende- und Empfangselement vertikal übereinander aufgebaut sind und
- Fig. 2: einen erfindungsgemäßen Optokoppler, bei dem Sende- und Empfangselement lateral nebeneinander angeordnet sind.

### Ausführungsbeispiel 1:

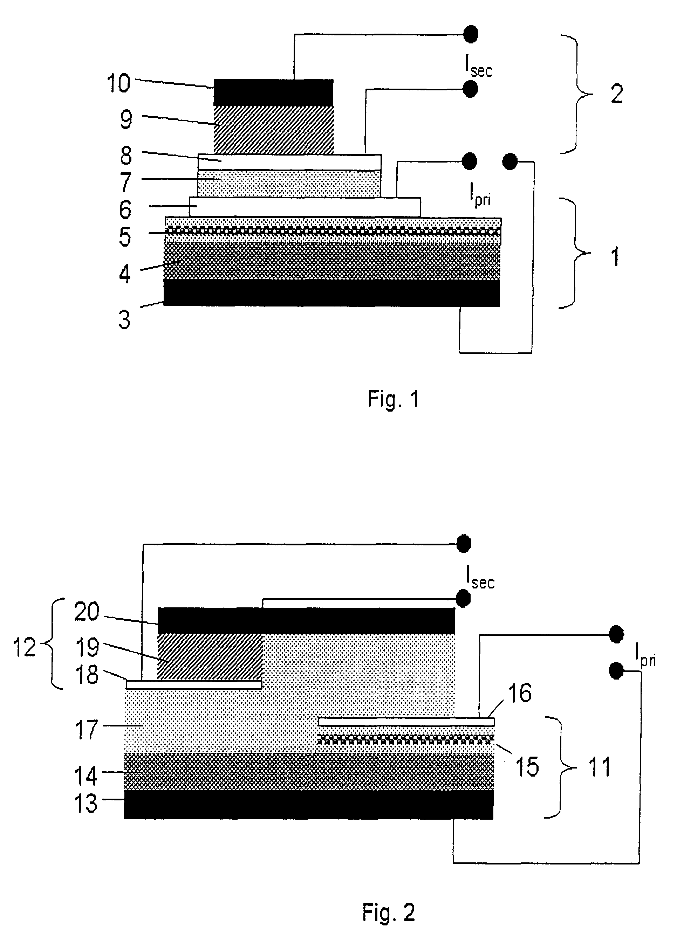

Der in Fig. 1 dargestellte Optokoppler zeigt als wesentliche Bestandteile Sender 1 und Empfänger 2, die vertikal übereinander in einer Schichtenfolge als monolithischer Block auf einem Siliziumwafer 4 angeordnet sind. Zwischen Sender 1 und Empfänger 2 befindet sich zur galvanischen Trennung eine optisch transparente Isolatorschicht 7.
Die Lichtemission des Senders 1 erfolgt durch Elektrolumineszenz aus modifizierten SiO₂. Schichten 5. Bei der Herstellung der Schichten 5 werden durch Änderungen in der Stöchiometrie oder durch das Einbringen von Fremdatomen Lumineszenzzentren erzeugt. Die Kontaktierung des Senders 1 erfolgt über eine abgeschiedene, optisch transparente Kontaktschicht 6 und den Kontakt auf der Waferrückseite 3.
Der Empfänger 2 besteht aus einer Photodiode 9, welche die vom Sender 1 emittierten Photonen absorbiert und die über eine optisch transparente Kontaktschicht 8 und einen Kontakt an der Schichtoberseite 10 betrieben wird.

### Ausführungsbeispiel 2:

Der in Fig. 2 dargestellte Optokoppler besteht im wesentlichen aus Sender 11 und Empfänger 12, wobei der Empfänger 12 nicht direkt über dem Sender 11 angeordnet ist. Der Optokoppler ist auf einem Siliziumsubstrat 14 aufgebaut. Die galvanische Trennung zwischen Sender 11 und Empfänger 12 erfolgt mittels einer optisch transparenten Isolatorschicht 17. Die anwendungsbedingte Spannungsfestigkeit wird über die Dicke dieser Isolatorschicht 17 bzw. über den lateralen Abstand von Sender 11 und Empfänger 12 eingestellt.
Die Lichtemission des Senders 11 erfolgt durch Elektrolumineszenz aus modifizierten SiO₂-Schichten 15. Der Sender 11 ist über eine abgeschiedene, optisch transparente Kontaktschicht 16 und den Kontakt auf der Waferrückseite 13 kontaktiert.
Der Empfänger 12 besteht aus einer Photodiode 19, welche die vom Sender 11 emittierten Photonen absorbiert und die über eine optisch transparente Kontaktschicht 18 und einen Kontakt an der Oberseite der Schicht 20 betrieben wird. Die Schicht 20 dient zugleich als Reflexionsschicht zur verbesserten Lichteinkopplung in den Empfänger 12.

### Ausführungsbeispiel für das Verfahren:

Die Herstellung des Optokopplers erfolgt in herkömmlicher Si-Technologie. Damit ist die Möglichkeit der Integration in bestehende Herstellungsprozesse und der Einsatz für zukünftige Anwendungen im Bereich der Intra- und Interchipkommunikation möglich.
Auf einem Silizium-Wafer wird eine dielektrische Schicht erzeugt. Diese Schicht wird während des Abscheideprozesses durch Änderung der Stöchiometrie oder durch im Anschluss erfolgende Ionenstrahlsynthese dahingehend modifiziert, dass in der Schicht Nanocluster erzeugt werden, die bei elektrischer Anregung Lumineszenz hervorrufen. Zur Kontaktierung des Senders wird eine optisch transparente und elektrisch leitfähige Schicht abgeschieden wie Indium-Zinnoxid (ITO), andere leitfähige transparente Oxide (TCO) oder dünne lichtdurchlässige Metallschichten. Auf diese wird zur galvanischen Trennung eine Isolatorschicht wie SiO₂ aufgebracht. Die entsprechend der Anwendung zu erreichende Spannungsfestigkeit kann über die Dicke dieser Schicht eingestellt werden. Es sind auch organische transparente isolierende Schichten, wie zum Beispiel Lacke oder Folien, anwendbar. Auf der Isolatorschicht wird eine weitere Kontaktschicht abgeschieden, die den Rückkontakt des Empfängers darstellt. Als Empfänger kann eine mittels eines CVD Verfahrens hergestellte pin-Diode, basierend auf amorphem Silizium, dienen. Ein abschließender Al-Metallisierungsschritt stellt den Rückkontakt des Empfängers her. Die Rückseite des Wafers wird ebenfalls mit A1 beschichtet und dient als Rückkontakt für das Emitterelement.

### Zu den Parametern:

Auf einem n-Typ (100) Si-Wafer lässt man eine 100 bis 500 nm dicke SiO₂ Schicht thermisch aufgewachsen. Anschließend wird mit Ge⁺ Ionen der Energie 50 bis 300 keV mit einer Fluenz von 6x10¹⁴ bis 4x10¹⁶ Ionen/cm² implantiert. Danach erfolgt eine Kurzzeitausheilung (RTA-rapid thermal annealing) bei 900 bis 1000°C für 30 s unter einer Stickstoffatmosphäre. Durch einen Sputterprozeß wird eine 80 bis 150 nm dicke ITO-Schicht abgeschieden, die lithographisch strukturiert wird. Anstelle von ITO wären auch andere transparente leitfähige Oxide (TCO) oder dünne lichtdurchlässige Metallschichten denkbar. Eine im folgenden aufgesputterte SiO₂-Schicht mit 500 nm Dicke stellt die Isolation zwischen Sender und Empfänger dar. Die entsprechend der Anwendung zu erreichende Spannungsfestigkeit kann über die Dicke dieser Schicht eingestellt werden. Auf der Isolatorschicht wird eine weitere ITO-Schicht abgeschieden, die den Rückkontakt der Empfängerdiode darstellt. Nach der Strukturierung dieser Schicht wird über einen RIE-CF₄-Plasmamätzprozeß das Oxid strukturiert. Die ITO-Schicht wirkt dabei als Maske. Anschließend wird über ein CVD-Verfahren eine pin-Diode, basierend auf amorphem Silizium, aufgebracht. Ein abschließender Al-Metallisierungsschritt stellt den Rückkontakt der Diode her. Die Strukturierung der a-Si Schicht erfolgt über einen SF₆-Plasmaätzprozeß, wobei der bereits strukturierte Al-Kontakt als Maske dient. Die Rückseite des Wafers wird ebenfalls mit A1 beschichtet und dient als Rückkontakt für den Sender.

## Patentansprüche

1. Integrierter Optokoppler, bestehend aus einem Substrat, auf dem sich ein Empfangs- und ein Sendeelement befindet, wobei Empfangs- und Sendeelement benachbart angeordnet und durch ein optisch transparentes und elektrisch isolierendes Material galvanisch getrennt sind, **dadurch gekennzeichnet**,
dass das Sendeelement (1) eine nanoclusterhaltige dielektrische Schicht (5) enthält und
dass Empfangs- und Sendeelement (1;2) aus einem monolithischen Block bestehen.

2. Optokoppler nach Anspruch 1, **dadurch gekennzeichnet, dass** Empfangs- und Sendeelement (1;2) vertikal übereinander angeordnet sind.

3. Optokoppler nach Anspruch 1, **dadurch gekennzeichnet, dass** Empfangs- und Sendeelement (1;2) lateral nebeneinander angeordnet sind.

4. Verfahren zur Herstellung eines integrierten Optokopplers, bei dem eine Mehrzahl von Schichten auf ein Substrat aufgebracht wird, **dadurch gekennzeichnet, dass** eine nanoclusterhaltige dielektrische Schicht durch Ionenstrahlsynthese erzeugt wird.

5. Verfahren zur Herstellung eines integrierten Optokopplers, bei dem eine Mehrzahl von Schichten auf ein Substrat aufgebracht wird, **dadurch gekennzeichnet, dass** eine nanoclusterhaltige SiOₓ-Schicht durch plasmagestützte Verfahren unter Variation der Stöchiometrie erzeugt und danach ausgeheilt wird.
